# EUROPÄISCHE PATENTSCHRIFT

(11) **EP 1 764 648 B1**
(45) Veröffentlichungstag und Bekanntmachung des Hinweises auf die Patenterteilung: **23.05.2012**
(21) Anmeldenummer: 05019943.9
(22) Anmeldetag: 14.09.2005
(51) Int. Cl.: G03F 7/00, B41D 7/04

(54) **Stempel mit einer Nanostempelstruktur sowie Vorrichtung und Verfahren zu dessen Herstellung**
Stamp with nanostructures and device as well as process for its production
Tampon avec nanostructures ainsi que appareil et procédé pour sa réalisation

(43) Veröffentlichungstag der Anmeldung: 21.03.2007
(73) Patentinhaber: Thallner, Erich, 4782 St. Florian (AT)
(72) Erfinder: Thallner, Erich, 4782 St. Florian (AT)
(74) Vertreter: Schweiger, Johannes

(56) Entgegenhaltungen:
- WO-A-02/42844
- US-A1- 2002 167 649
- US-A1- 2003 213 382
- ISLAM R ET AL: "One micron precision optically aligned method for hot-embossing and nanoirnprinting" PROCEEDINGS OF IEEE SENSORS 2002. ORLANDO, FL, JUNE 12 - 14, 2002, IEEE INTERNATIONAL CONFERENCE ON SENSORS, NEW YORK, NY : IEEE, US, Bd. VOL. 1 OF 2. CONF. 1, 12. Juni 2002 (2002-06-12), Seiten 931-935, XP010605233 ISBN: 0-7803-7454-1
- XIAO PENGFENG ET AL: "Fabrication of microstamps used for oligonucleotide arrays synthesis" PROC SPIE INT SOC OPT ENG; PROCEEDINGS OF SPIE - THE INTERNATIONAL SOCIETY FOR OPTICAL ENGINEERING 2001, Bd. 4601, 2001, Seiten 401-405, XP002380795
- ABAD E ET AL: "Soft lithographic patterning of oxide thin films" PROCEEDINGS OF THE SPIE - THE INTERNATIONAL SOCIETY FOR OPTICAL ENGINEERING SPIE-INT. SOC. OPT. ENG USA, Bd. 5116, 2003, Seiten 176-184, XP002380796 ISSN: 0277-786X
- LIBIOULLE LAURENT ET AL: "Contact-inking stamps for microcontact printing of alkanethiols on gold" LANGMUIR, AMERICAN CHEMICAL SOCIETY, NEW YORK, NY, US, Bd. 15, Nr. 2, 19. Januar 1999 (1999-01-19), Seiten 300-304, XP002215410 ISSN: 0743-7463
- XIA Y ET AL: "SOFT LITHOGRAPHY" ANGEWANDTE CHEMIE. INTERNATIONAL EDITION, WILEY VCH VERLAG, WEINHEIM, DE, Bd. 37, 1998, Seiten 551-575, XP000985399 ISSN: 1433-7851

## Beschreibung

Die Erfindung betrifft einen Stempel mit einer Nanostempelstruktur zur Aufbringung von Nanostrukturen auf Bauteile, sowie eine Vorrichtung und ein Verfahren zur Herstellung des Stempels.

In der Halbleiterindustrie ist es notwendig, sehr kleine Strukturen, beispielsweise auf Waferscheiben, Metalle, Kunststoffe oder ähnliche Materialien bzw. Bauteile zu übertragen.

Allgemein bekannter Stand der Technik ist es, diese Strukturen mittels Fotolithographie zu erzeugen. Hierzu werden die Wafer oder die anderen Bauteile mit Fotolack beschichtet und danach durch geeignete Belichtungsgeräte belichtet. In einem darauf folgenden Entwicklungsprozess werden die Strukturen erzeugt.

Eine weitere Möglichkeit, Nanostrukturen zu erzeugen, ist durch sogenannte Direktschreibverfahren mittels E-Beam-Geräten oder Ionenstrahlschreibern gegeben. Auch ist das Erzeugen von Nanostrukturen mittels Röntgenstrahlen bekannt.

Neuere Methoden verwenden zum Aufbringen von Nanostrukturen in Bauteiloberflächen Stempel- oder Prägeverfahren. Bei der sogenannten

Stempelmethode werden flexible Stempel aus Poly-Dimethyl-Siloxan (PDMS) verwendet. Diese Technologie ist beispielsweise in den Druckschriften US 2004/0011231 A1, US 5,817,242 sowie WO 2003/099463 A3 beschrieben.

Weitere Druckschriften mit solchen Stempeln, Verfahren und Vorrichtungen sind: WO 02/42844, R. Islam et al: "one micron precision optically aligned method for hot-embossing and nanoirnprinting", Xiao Pengfeng et al: "Fabrication of microstamps used for oligonucleotide arrays synthesis" und US 2003/213352 A1.

Bei den bekannten Prägetechniken ist der maximal mögliche Strukturübertragungsbereich klein. Typischerweise beträgt dieser etwa 625 mm² und ist daher zur Herstellung flächiger großer Bereiche, wie für Datenspeichermedien ungeeignet.

Der Erfindung liegt daher die Aufgebe zugrunde, einen Stempel mit einer Nanostruktur sowie eine Vorrichtung und ein Verfahren zu dessen Herstellung vorzuschlagen, mit dem großflächig Nanostrukturen auf Bauteiloberflächen aufgebracht werden können.

Diese Aufgabe wird mit den Merkmalen der Ansprüche 1, 11 und 25 gelöst.

Der Erfindung liegt der Gedanke zugrunde, die Nanostempelstruktur an einen starren Träger zu binden. Dabei sollte auf eine möglichst innige Verbindung zwischen der Nanostempelstruktur und dem Träger geachtet werden. Im Gegensatz zu den bekannten, flexiblen PDMS-Stempeln ist es mit dem erfindungsgemäßen Stempel mit starrem Träger möglich, Nanostrukturen über eine große Fläche ohne ein sogenanntes "run out" zu realisieren. Der Nachteil der bekannten flexiblen Stempel, sich bei dem Stempelprozess zu verformen, was zu Verzeichnungen und Verzerrungen in der einzubringenden Nanostruktur führt, wird mit Vorteil vermieden. Der erfindungsgemäße Stempel eignet sich daher besonders für die Aufbringung von Nanostrukturen für Festplattenspeicherscheiben, für die Flatpanel-Strukturierung sowie für die Aufbringung von Nanostrukturen auf Wafer in sogenannten Full-Wafer-Strukturierungsprozessen. Der erfindungsgemäße Stempel kann jedoch auch für die Aufbringung von Nanostrukturen auf kleinere Flächen, beispielsweise im sogenannten Step- und Repeat-Verfahren, eingesetzt werden.

Die Nanostempelstruktur des Stempels besteht aus einem ausgehärteten Polymer . Hierfür eignen sich insbesondere Elastomere, bevorzugt Siloxane. Mit Vorteil besteht die Nanostempelstruktur aus ausgehärtetem Poly-Dimethyl-Siloxan (PDMS).

Zur Herstellung einer besonders innigen Verbindung zwischen der Nanostempelstruktur und dem Träger, ist es von entscheidendem Vorteil, wenn der Träger zumindest in einem Teilbereich aus porösem und/oder mit Kanälen durchzogenen Material besteht. Bei der Herstellung des Stempels kann das noch flüssige Polymer in die Poren und/oder Kanäle bzw. Kapillaren des Trägers eindringen. Bei der Herstellung des Stempels wird hierzu insbesondere ein Vakuum an den Träger angelegt, um das flüssige Polymer definiert aufzusaugen. Nach dem Aushärten des Polymers ist die Nanostruktur fest in dem Träger verwurzelt. Es ist auch denkbar, zusätzlich oder alternativ, das flüssige Polymer mittels Überdruck in die Poren bzw. Kanäle "hineinzudrücken". Ein weiterer wesentlicher Vorteil der speziellen Ausgestaltung des Trägers besteht darin, dass der Träger in einem späteren Stempelprozess mit eindiffundierenden Substanzen, wie beispielsweise Thiolen oder Proteinen, benetzt werden kann. Der poröse bzw. mit Kanälen durchzogene Träger saugt sich mit diesen Substanzen voll und gibt diese über die Nanostempelstruktur beim Stempelprozess auf das zu strukturierende Substrat, beispielsweise Edelmetall, ab. Die Notwendigkeit einer Benetzung vor jedem Stempelprozess entfällt somit. Der Träger bildet einen Speicher für diese Substanzen.

Als Materialien zur Herstellung des Trägers eignen sich insbesondere Keramikmaterialien mit sehr kleiner Korngröße. Mit Vorteil handelt es sich um gesintertes Keramikmaterial.

Um den erfindungsgemäßen Stempel zu dem zu strukturierenden Substrat genau justieren zu können, sind in Weiterbildung der Erfindung Justierungsmittel vorgesehen. Es besteht beispielsweise die Möglichkeit elektrisch oder elektronisch detektierbare Medien oder Materialien an dem Stempel zu befestigen oder in diesen, insbesondere in das Trägermaterial, zu integrieren. Auch können farbige oder flureszierende oder sich unter bestimmten physikalischen Bedingungen verändernde Substanzen als Justierungsmittel verwendet werden.

Mit Vorteil sind die Justierungsmittel auf der der Nanostempelstruktur gegenüberliegenden Seite des Trägers angeordnet. Hierdurch wird die Möglichkeit geschaffen, den Stempel von der der Nanostempelstruktur gegenüberliegenden Seite her zu justieren.

In Weiterbildung der Erfindung ist mit Vorteil vorgesehen, dass die Justierungsmittel als dreidimensionale Justierungsmarken ausgebildet sind. Mit Vorteil werden die Justierungsmarken während der Herstellung der Nanostempelstruktur auf den Träger aufgebracht, wodurch nach einem Vermessungsschritt eine genaue definierte Zuordnung zu der Nanostempelstruktur des Stempels gegeben ist. Zur Justierung des Stempels zu dem zu strukturierenden Substrat eignen sich insbesondere optische oder mechanische Justierungssysteme. Beispielsweise können die Justierungsmarken mechanisch mittels AFM-Nadeln abgetastet werden.

Bevorzugt werden die Justierungsmarken nach dem gleichen Prinzip hergestellt wie die Nanostempelstruktur. Mit Vorteil bestehen die Justierungsmarken aus einem ausgehärteten Polymer, insbesondere einem Elastomer, vorzugsweise einem Siloxan, bevorzugt aus PDMS. Das Material für die Justierungsmarken muss nicht zwingend mit dem Material zur Herstellung der Nanostempelstruktur übereinstimmen.

Die erfindungsgemäße Vorrichtung zur Herstellung des Stempels umfasst erfindungsgemäß ein Aufnahmemittel zur Aufnahme eines starren Trägers. Die Träger sind in der Regel als flache Platten mit zwei gegenüberliegenden, ebenen sowie parallelen Seitenflächen ausgebildet. Die erfindungsgemäße Vorrichtung umfasst ferner mindestens einen relativ zu dem starren Träger bewegbaren Masterstempel mit einer Nanostrukturoberfläche. Des Weiteren ist in Ausgestaltung der Erfindung vorgesehen, dass mindestens ein Aufbringmittel zum Aufbringen eines fließfähigen, aushärtbaren Polymers, insbesondere eines Elastomers, vorzugsweise eines Siloxans, bevorzugt von PDMS auf den Träger und/oder den Masterstempel in die Vorrichtung zu integrieren. Bevorzugt sind die Aufbringmittel als Düsen ausgebildet.

Zunächst wird ein starrer Träger in das Aufnahmemittel eingebracht, bevorzugt eingeschoben oder eingelegt. Daraufhin wird mittels des Aufbringmittels, beispielsweise auf die Oberseite des starren Trägers, das fließfähige Polymer aufgebracht. Daraufhin erfolgt eine Relativbewegung zwischen Masterstempel und Träger in der Art, dass die Nanostrukturoberfläche des Masterstempels in das fließfähige Polymer eintaucht. Hierdurch wird die Nanostruktur des Materstempels in das fließfähige Polymer übertragen.

Es ist von Vorteil, wenn der Masterstempel und der Träger innerhalb einer gegenüber der Atmosphäre/Umgebung dichten Kammer angeordnet sind, wobei die Kammer eine Umfangswand aufweist. Hierdurch ist es möglich, die Druckverhältnisse innerhalb der Kammer steuern zu können, so dass das Eintauchen des Masterstempels in das flüssige Polymer blasenfrei erfolgt.

In Weiterbildung der Erfindung ist vorgesehen, dass die Seite des Trägers, auf die die Nanostempelstruktur aufgebracht werden soll, parallel zu der Nanostrukturoberfläche des Masterstempels angeordnet ist. Dabei ist es von Vorteil, wenn der Masterstempel oberhalb des starren Trägers angeordnet ist und die Nanostrukturoberfläche des Masterstempels nach unten in Richtung des starren Trägers gerichtet ist. Bei der beschriebenen Konfiguration wird das fließfähige Polymer direkt auf den starren Träger aufgebracht. Der Masterstempel wird relativ zu dem starren Träger bewegt, sodass die Nanostrukturoberfläche des Masterstempels in Kontakt mit dem fließfähigen Polymer kommt.

Bevorzugt erfolgt die Bewegung des Masterstempels innerhalb der Kammer translatorisch auf den Träger zu. Dabei sollte der Masterstempel soweit wie möglich bis an den Träger heran verfahren werden. Hierdurch entsteht eine extrem dünne Polymerschicht, bevorzugt eine PDMS-Schicht. Durch diese Maßnahme wird die Flexibilität der Nanostempelstruktur lediglich durch die erhabene Struktur selbst erhalten. Die erhabenen Strukturen sind mit dem festen Träger vertikal verbunden. Die Strukturen haben keine flexible Verbindung untereinander. Hierdurch treten Verzerrungen und Verzeichnungen während eines späteren Stempelprozesses nicht mehr auf.

Um die Bewegung des Masterstempels und/oder des Trägers exakt steuern zu können, ist in Ausgestaltung der Erfindung mindestens eine Messeinrichtung zur Messung der Position des Masterstempels und/oder des Trägers vorgesehen. Bevorzugt ist die Messeinrichtung auf der der Nanostrukturoberfläche des Masterstempels abgewandten Seite des Masterstempels angeordnet, wodurch der Abstand des sich bewegenden Masterstempels zur Messeinrichtung kontinuierlich gemessen werden kann.

Zum Anlegen eines Vakuums an den zumindest in einem Teilbereich aus porösem und/oder mit Kanälen durchzogenen Material bestehenden Träger ist mindestens eine erste Vakuumleitung vorgesehen. Bevorzugt ist die Vakuumleitung derart angeordnet, dass das Vakuum an der dem Masterstempel abgewandten Seite des Trägers anlegbar ist. Durch Anlegen eines Vakuums kann das fließfähige Polymer definiert in die Poren und/oder Kanäle bzw. Kapillaren des Trägers eingesaugt werden. Hierdurch wird zum einen die Dicke der entstehenden Nanostempelstruktur gesteuert. Weiterhin wird über den Einsaugprozess eine innige Verbindung zwischen der auf der Oberfläche des Trägers befindlichen Nanostempelstruktur und dem Träger durch das in den Träger eingedrungene fließfähige Polymer erzeugt. Der Einsaugprozess wird derart gesteuert, dass ein Teil des fließfähigen Polymers auf der Trägeroberfläche verbleibt und von der Nanostrukturoberfläche des Masterstempels geformt wird. Es ist auch denkbar, anstelle oder zusätzlich zu dem Vakuum einen Überdruck auf der Seite des Trägers mit dem fließfähigen Polymer anzulegen, um das fließfähige Polymer in die Poren bzw. Kanäle des Trägers hineinzudrücken.

In Ausgestaltung der Erfindung ist vorgesehen, dass der Masterstempel gegenüber der Umfangswand der Kammer abgedichtet ist und dass mindestens eine zweite Vakuum- und/oder Druckleitung zum Anlegen eines Vakuums oder eines Drucks auf der der Nanostrukturoberfläche gegenüberliegenden Seite des Masterstempels vorgesehen ist. Durch Anlegen eines Vakuums kann der Masterstempel fixiert werden. Durch Anlegen eines Drucks kann der Masterstempel in Richtung des starren Trägers verschoben werden. Der Masterstempel ist quasi als in einem Zylinder (Kammer) bewegbarer Kolben ausgebildet. Durch die gleichmäßige Druckverteilung auf der Masterstempelrückseite wird eine gleichmäßige Bewegung des Masterstempels ohne Verkanten gewährleistet.

Zusätzlich ist in Ausgestaltung der Erfindung vorgesehen, dass mindestens eine dritte Vakuum- und/oder Druckleitung zum Anlegen eines Vakuums oder eines Drucks in einem Bereich zwischen dem Masterstempel und dem Träger vorgesehen ist. Über diese dritte Vakuum- und/oder Druckleitung kann die Bewegung des Masterstempels und/oder des starren Trägers zusätzlich gesteuert werden. Gleichzeitig ist es möglich, über diese dritte Vakuumleitung einen Druck aufzubringen, der das fließfähige Polymer in die Poren bzw. Kanäle des Trägers hinein drückt.

Über die Steuerung der Druckverhältnisse wird ein blasenfreies Eintauchen des Masterstempels in das flüssige Polymer sichergestellt.

Es ist von besonderem Vorteil, wenn die Vorrichtung mindestens einen Justierungsmarkenstempel zum Einbringen einer dreidimensionalen Justierungsmarke in die von dem Masterstempel abgewandte Seite des Trägers umfasst. Dabei ist es sinnvoll, wenn der Träger auf den Justierungsmarkenstempel auflegbar ist, der Justierungsmarkenstempel also Teil der Halteeinrichtung für den starren Träger ist.

Bevorzugt ist der Justierungsmarkenstempel als Ring ausgebildet, so dass der Träger gleichmäßig mit einer umlaufenden Fläche auf dem Justierungsmarkenstempel aufliegt. Bevorzugt sind an mehreren definierten und in Umfangsrichtung beabstandeten Stellen des Rings Justierungsmarkenstrukturen vorgesehen. Es ist auch denkbar, den Justierungsmarkenstempel auf den Träger aufzulegen, oder den Träger an den Justierungsmarkenstempel anzupressen.

Mit Vorteil ist mindestens ein zweites Aufbringmittel zum Aufbringen eines fließfähigen, aushärtbaren Polymers, insbesondere eines Elastomers, vorzugsweise eines Siloxans, bevorzugt von PDMS auf den Justierungsmarkenstempel und/oder die von dem Masterstempel abgewandte Seite des Trägers vorgesehen. Es besteht jedoch die Möglichkeit, zur Aufbringung des fließfähigen Polymers zur Herstellung der Nanostempelstruktur sowie zur Aufbringung des fließfähigen aushärtbaren Polymers zur Herstellung der Justierungsmarken das oder die selben Aufbringmittel zu verwenden. Bevorzugt erfolgt die Aufbringung des fließfähigen Polymers auf den Justierungsmarkenstempel vor dem Einlegen des Trägers.

Die chemische Zusammensetzung des Polymers zur Herstellung der Justierungsmarken kann von der chemischen Zusammensetzung zur Herstellung der Nanostempelstruktur abweichen. Es ist zur Herstellung der Justierungsmarken denkbar, fluoreszierende oder färbende oder unter bestimmten physikalischen Umständen sich ändernde Substanzen zu verwenden.

In Weiterbildung der Erfindung ist mindestens eine Aushärteinrichtung, vorzugsweise eine Heizung, zur Aushärtung der Nanostempelstruktur und/oder der dreidimensionalen Justierungsmarken vorgesehen. Je nach verwendetem Material kann anstelle oder zusätzlich einer Heizung beispielsweise eine UV-Leuchteinheit verwendet werden. Mit Vorteil werden die Justierungsmarken und die Nanostempelstruktur gleichzeitig in einem gemeinsamen Aushärtprozess ausgehärtet. Hierdurch wird eine definierte Zuordnung der Justierungsmarken zu der Nanostempelstruktur des Trägers geschaffen.

In Ausgestaltung der Erfindung umfasst die Vorrichtung mindestens eine Heizung, welche auf der der Nanostrukturoberfläche gegenüberliegenden Seite des Masterstempels angeordnet ist. Zusätzlich oder alternativ kann mindestens eine weitere Heizung auf der dem Masterstempel abgewandten Seite des Trägers vorgesehen werden. Insbesondere durch das Vorsehen von zwei Heizungen wird die Aushärtezeit minimiert und ein gleichmäßiger Temperaturverlauf gewährleistet.

Gemäß einer vorteilhaften Weiterbildung der Erfindung ist vorgesehen, dass die Kammer einen ersten Kammerabschnitt für den Masterstempel und einen gegenüber dem ersten Kammerabschnitt abdichtbaren zweiten Kammerabschnitt für den Träger aufweist und dass Mittel zum Öffnen und Schließen der Kammer durch Bewegung mindestens eines Kammerabschnitts vorgesehen sind. Der zweite Kammerabschnitt für den Träger bildet die Halteeinrichtung für den Träger. Nach dem Auseinanderbewegen der beiden Kammerabschnitte kann der fertige Stempel entnommen werden und ein neuer Träger eingelegt werden. Bevorzugt wird der neue Träger auf den Justierungsmarkenstempel aufgelegt, nachdem ein fließfähiges Polymer auf diesen aufgebracht wurde. Daraufhin wird die Kammer geschlossen, woraufhin die Aufbringung des fließfähigen Polymers zur Herstellung der Nanostempelstruktur erfolgt. Gleichzeitig mit dem Aufbringen des fließfähigen Polymers oder danach wird eine Relativbewegung zwischen dem Träger und dem Masterstempel in Lauf gesetzt. Bevorzugt erfolgt gleichzeitig das Einsaugen des fließfähigen Polymers in den porösen oder mit Kanälen durchzogenen Träger. Dabei wird fließfähiges Polymer sowohl von der dem Masterstempel zugewandten Seite des Trägers eingesaugt, als auch von der dem Justierungsmarkenstempel zugewandten Seiten her. Nach Abschluss des Einsaugprozesses erfolgt die Aushärtung des fließfähigen Polymers, bevorzugt mittels zweier Heizungen.

Eine Möglichkeit, den ersten Kammerabschnitt relativ zu dem zweiten Kammerabschnitt zu bewegen, besteht darin, eine Rotationsbewegung zwischen den Kammerabschnitten über ein Schwenkgelenk auszuführen.

Eine weitere Möglichkeit besteht darin, einen Kammerabschnitt translatorisch auf den jeweils anderen Kammerabschnitt zu bzw. von diesem weg zu bewegen. Beispielsweise ist die Bewegung mittels eine Hubzylinders denkbar. Weiterhin können zusätzlich seitliche Führungen vorgesehen werden. Auch ist eine kombinierte rotatorisch-translatorische Bewegung, beispielsweise über eine Viergelenkkinematik, denkbar.

Weiterhin ist Gegenstand der Erfindung ein Verfahren zur Herstellung eines Stempels mit einer Nanostempelstruktur. Gemäß dem erfindungsgemäßen Verfahren ist vorgesehen, dass nach dem Einbringen eines porösen oder mit Kanälen durchzogenen Trägers in eine Halteeinrichtung ein aushärtbares Polymer, insbesondere ein Elastomer, vorzugsweise ein Siloxan, bevorzugt PDMS auf den starren Träger und/oder die Nanostrukturoberfläche eines Masterstempels aufgebracht wird. Daraufhin wird der Abstand zwischen dem Masterstempel und dem starren Träger verringert, wodurch die Nanostrukturoberfläche des Masterstempels in das fließfähige Polymer eintaucht. In einem späteren Schritt wird das Polymer, bevorzugt mittels einer Heizung, ausgehärtet.

Um eine optimale Verbindung zwischen der aus dem Polymer herzustellenden Nanostempelstruktur und dem Träger zu schaffen, wird in Ausgestaltung der Erfindung ein Vakuum an den Träger angelegt, wodurch eine Teilmenge des Polymers in die Poren bzw. Kanäle des Trägers eingesaugt wird. Zusätzlich oder alternativ kann auch ein Druck angelegt werden, so dass das fließfähige Polymer in die Poren und/oder Kanäle des Trägers hinein gedrückt wird.

Während des Herstellungsverfahrens der Nanostempelstruktur wird in Ausgestaltung der Erfindung auch eine dreidimensionale Justierungsmarke in den Träger, bevorzugt in die dem Masterstempel abgewandte Seite des Trägers, eingebracht.

Diese Justierungsmarke wird bevorzugt ebenfalls aus einem fließfähigen Polymer, insbesondere einem Elastomer, vorzugsweise einem Siloxan, bevorzugt aus PDMS hergestellt. Bevorzugt erfolgt die Aushärtung der Justierungsmarken und der Nanostempelstruktur gleichzeitig, sodass eine definierte Zuordnung zwischen Justierungsmarke und Nanostempelstruktur geschaffen wird.

Weitere Vorteile und zweckmäßige Ausführungen sind den weiteren Ansprüchen, der Figurenbeschreibung und den Zeichnungen zu entnehmen. Insbesondere wesentliche Verfahrensmerkmale sind der Figurenbeschreibung zu entnehmen. Es zeigen:
- Fig. 1: eine Vorrichtung zur Herstellung eines Stempels mit einer Nanostempelstruktur, mit zwei Kammerabschnitten im geöffneten Zustand,
- Fig. 2: die Vorrichtung gemäß Fig. 1 mit geschlossenen Kammerabschnitten,
- Fig. 3: einen als Ring ausgebildeten Justierungsmarkenstempel mit Justierungsmarkenstrukturen und
- Fig. 4: einen Stempel.

In den Figuren sind gleiche Bauteile sowie Bauteile mit gleicher Funktion mit den gleichen Bezugszeichen versehen.

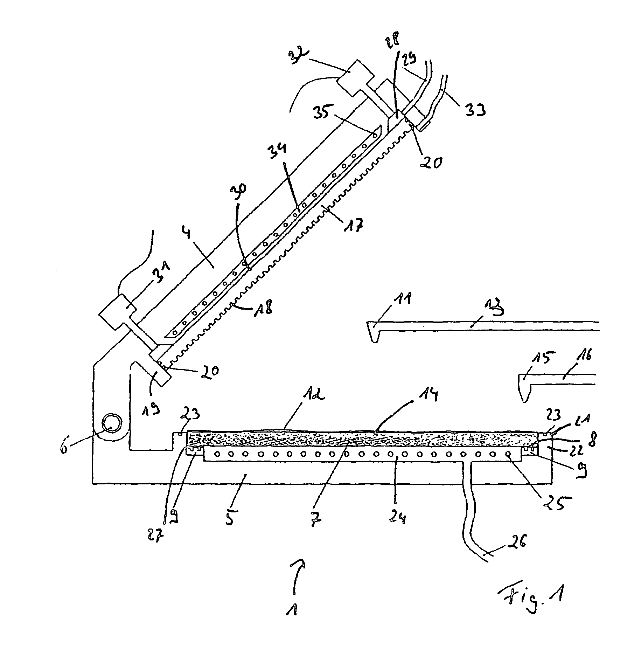

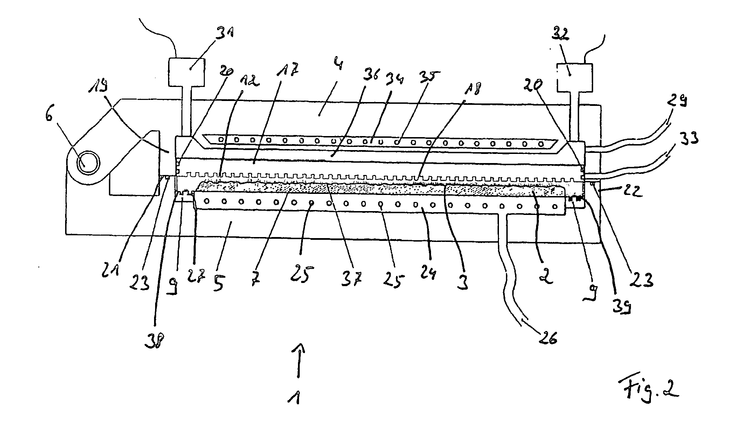

In Fig. 1 ist eine Vorrichtung 1 zur Herstellung eines Stempels 2 mit einer Nanostempelstruktur 3 (siehe Fig. 2) dargestellt.

Die Vorrichtung 1 weist einen ersten und einen zweiten Kammerabschnitt 4, 5 auf, wobei die beiden Kammerabschnitte 4, 5 gelenkig über ein Schwenkgelenk 6 miteinander verbunden sind. Der untere, zweite Kammerabschnitt 5 ist horizontal ausgerichtet und dient als Halteeinrichtung für einen Träger 7 für die aufzubringende Nanostempelstruktur 3.

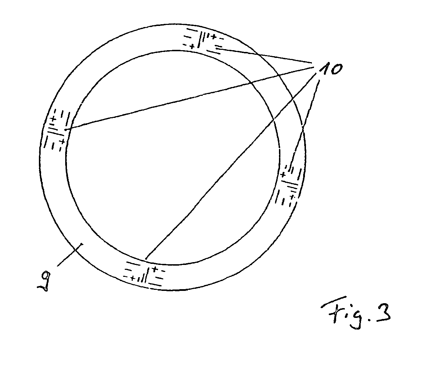

Der Träger 7 liegt mit seinem umlaufenden Randbereich 8 auf einem ringförmigen Justierungsmarkenstempel 9 auf. Der Justierungsmarkenstempel 9 ist in Fig. 3 in einer Draufsicht dargestellt. Wie aus Fig. 3 ersichtlich ist, weist der Justierungsmarkenstempel 9 mehrere über den Umfang verteilte Justierungsmarkenstrukturen 10 zur Einbringung von entsprechenden Justierungsmarken auf den darüber angeordneten Träger 7 auf.

Weiterhin weist die Vorrichtung ein als Düse 11 ausgebildetes erstes Aufbringmittel zur Aufbringung von fließfähigem Poly-Dimethyl-Siloxan (PDMS) 12 auf den porösen Träger 7 auf. Die Düse 11 ist mit einer Zuleitung 13 verbunden. Der Zuleitung 13 ist eine nicht dargestellte Dosiereinrichtung zur dosierten Aufbringung des fließfähigen PDMS auf eine Oberseite 14 des porösen, starren Trägers 7 zugeordnet.

Unterhalb der Düse 11 mit Zuleitung 13 befindet sich ein ebenfalls als Düse 15 ausgebildetes zweites Aufbringmittel zur Aufbringung von PDMS auf die Oberseite des Justierungsmarkenstempels 9. Bei dem gezeigten Ausführungsbeispiel erfolgt die Aufbringung von PDMS 27 auf den Justierungsmarkenstempel 9 vor dem Einlegen des porösen Trägers 7 in den zweiten Kammerabschnitt 5. Die zweite Düse 15 ist mit einer Zuleitung 16 verbunden, die zu einer nicht gezeigten Dosiereinrichtung mit Pumpe führt.

In den ersten Kammerabschnitt 4 ist ein Masterstempel 17 mit einer Nanostrukturoberfläche 18 angeordnet. Der Masterstempel 17 ist gegenüber einer Umfangswand 19 des ersten Kammerabschnitts 4 mittels zweier übereinander angeordneter O-Ringe 20 abgedichtet. Die O-Ringe 20 sind derart beschaffen, dass der Masterstempel 17 entlang der Umfangswand 19 translatorisch bewegt werden kann.

Auf der Oberseite 21 einer Umfangswand 22 des zweiten Kammerabschnitts ist eine umlaufende Ringdichtung 23 angeordnet. Diese ermöglicht eine dichtende Verbindung zwischen dem ersten Kammerabschnitt 4 und dem zweiten Kammerabschnitt 5, wie dies in Fig. 2 dargestellt ist.

Unterhalb des porösen Trägers 7 und seitlich innerhalb des ringförmigen Justierungsmarkenstempels 9 ist ein sich nahezu über die gesamte Flächenausdehnung des Trägers 7 erstreckender Hohlraum 24 vorgesehen. Die Oberseite des Hohlraums 24 wird von dem porösen Träger 7 gebildet. Innerhalb des Hohlraums 24 sind eine Vielzahl beabstandeter Heizwendeln 25 angeordnet. Diese dienen zur späteren Aushärtung des auf den Justierungsmarkenstempel 9 aufgebrachten PDMS 27 sowie zur Aushärtung des auf den Träger 7 über die Düse 11 aufgebrachten PDMS 12.

In den Hohlraum 24 mündet eine erste Vakuumleitung 26, mit der ein Unterdruck in dem Hohlraum 24 erzeugbar ist. Dieser Unterdruck wirkt auf den porösen Träger 7, wodurch eine Teilmenge des auf diesen aufgebrachten PDMS 12 sowie eine Teilmenge des auf den Justierungsmarkenstempel 9 aufgebrachten PDMS 27 in die Poren des starren Trägers eingesaugt werden kann.

Oberhalb des Masterstempels 17 ist in den ersten Kammerabschnitt 4 eine umlaufende Ringnut 28 eingebracht. In diese mündet eine zweite Vakuum-/Druckleitung 29. Über die Leitung 29 ist sowohl ein Unterdruck als auch ein Überdruck auf der dem Träger 7 abgewandten Seite 30 erzeugbar. Bei dem Anlegen eines Unterdrucks wird der Masterstempel 17 in dem ersten Kammerabschnitt 4 gehalten. Bei Herstellung von Normaldruck oder bei Beaufschlagung des Bereichs hinter der Seite 30 des Masterstempels 17 mit Überdruck bewegt sich der Masterstempel 17 translatorisch in Richtung des starren Trägers 7.

In die Ringnut 28 münden zwei beabstandete Messeinrichtungen 31, 32, mit denen die Position des Masterstempels 17 und damit der Abstand zwischen der Nanostrukturoberfläche 18 des Masterstempels 17 und dem Träger 7 bestimmbar ist.

Mit Abstand zu der zweiten Vakuum-/Druckleitung 29 ist eine dritte Vakuum-/Druckleitung 33 angeordnet, die in einen Bereich zwischen dem Masterstempel 17 und dem Träger 7 mündet. Beide Vakuum-/Druckleitungen 29, 33 sind seitlich durch die Umfangswand 19 des ersten Kammerabschnitts 4 geführt. Mittels der dritten Vakuum-/Druckleitung 33 kann ein Unterdruck und/oder ein Überdruck in dem Bereich zwischen dem Masterstempel 17 und dem Träger 7 erzeugt werden.

Oberhalb des Masterstempels 17 ist innerhalb des ersten Kammerabschnitts 4 ein zweiter Hohlraum 34 eingebracht. In diesem zweiten Hohlraum 34 befinden sich mehrere beabstandete Heizwendeln 35 zur Aushärtung des aufgebrachten PDMS.

In Fig. 2 ist die aus dem ersten Kammerabschnitt 4 und dem zweiten Kammerabschnitt 5 gebildete Kammer 36 geschlossen und gegenüber der Atmosphäre/Umgebung über die Ringdichtung 23 abgedichtet.

Beide Düsen 11, 15 mit ihren Leitungen 13, 16 sind aus dem Bereich innerhalb der Kammer 36 heraus geschwenkt. Über die Vakuumleitung 26 ist ein Vakuum an den Hohlraum 24 angelegt, wodurch eine Teilmenge 37 des auf den Träger 7 aufgebrachten PDMS 12 in die Poren des Trägers 7 eingesaugt wird. Weiterhin ist eine Teilmenge 38 des auf den Justierungsmarkenstempel 9 aufgebrachten PDMS 27 in die Poren des Trägers 7 eingesaugt.

An der zweiten Vakuum-/Druckleitung 29 liegt Normaldruck an. Der Masterstempel ist bis auf den Träger 7 translatorisch aufgefahren, wobei die Position des Masterstempels über die Messeinrichtungen 31, 32 bestimmt wird. Die dritte Vakuum-/Druckleitung 33 hat in dem in Fig. 2 dargestellten Zustand keine Funktion mehr. Die Leitung 33 wird von der Umfangsseite des Masterstempels 17 abgedichtet.

Im Folgenden wird das Verfahren zur Herstellung des Stempels erläutert.

Zunächst sind die beiden Kammerabschnitte 4, 5, wie in Fig. 1 gezeigt, geöffnet. Nun wird über die Düse 15 PDMS 27 auf die mit Justierungsmarkenstrukturen 10 versehene Oberseite 10 des ringförmigen Justierungsmarkenstempels 9 aufgebracht. Daraufhin wird der poröse Träger 7 auf den mit PDMS 27 beschichteten ringförmigen Justierungsmarkenstempel 9 aufgelegt. Hierdurch wird unterhalb des Trägers 7 ein geschlossener Hohlraum gebildet. Daraufhin wird die Oberseite 14 des Trägers 7 über die Düse 11 und daran anschließende Leitung 13 mit flüssigem PDMS 12 beschichtet.

In dem darauf folgenden Schritt werden die Düsen 11, 15 mit den dazugehörigen Leitungen 13, 16 aus dem Bereich zwischen dem ersten Kammerabschnitt 4 und dem zweiten Kammerabschnitt 5 herausgeschwenkt.

Daraufhin erfolgt das Schließen der Kammer 36 durch Verschwenken des ersten Kammerabschnitts 4 um das Schwenkgelenk 6. Hierzu kann ein nicht dargestellter motorischer Antrieb vorgesehen sein. Die Umfangswand 10 des ersten Kammerabschnitts 4 liegt auf der Umfangswand 22 des zweiten Kammerabschnitts 5 auf. Die Abdichtung erfolgt über die Ringdichtung 23 auf der Oberseite 21 der Umfangswand 22 des zweiten Kammerabschnitts 5.

An der zweiten Vakuum-/Druckleitung 29 ist ein Vakuum angelegt, um den Masterstempel 17 in der in Fig. 1 dargestellten oberen Position zu halten. Nach einer vorgegebenen Zeit wird an die Leitungen 26, 33 ebenfalls Vakuum angelegt. Durch die Beaufschlagung des Hohlraums 24 über die Vakuumleitung 26 mit Unterdruck wird eine Teilmenge 37 des PDMS 12 sowie eine Teilmenge 38 des PDMS 27 in die Poren des starren Trägers 7 eingesaugt. Das PDMS haftet somit innerhalb des Stempelmaterials.

Nach einer einstellbaren Evakuierungszeit wird die zweite Vakuum-/Druckleitung 29 dem atmosphärischen Druck ausgesetzt. Zu einem späteren Zeitpunkt wird auch die dritte Vakuum-/Druckleitung 33 des atmosphärischen Druck ausgesetzt. Der Masterstempel 17 wandert in Richtung auf den Träger 7 zu, wobei die Nanostrukturoberfläche 18 in das auf der Oberseite 14 des Trägers 7 befindliche PDMS 12 eintaucht. Der Masterstempel 17 fährt bis an den Träger 7 heran, um eine möglichst dünne Nanostempelstruktur aus PDMS zu verhalten. Die Position des Masterstempels 17 wird über die Messeinrichtungen 31, 32 bestimmt. Das Messergebnis dient als Steuergröße für eine nicht dargestellte Bewegungssteuereinheit, die auch die Beaufschlagung der Vakuum-/Druckleitungen 26, 29 und 33 steuert. Durch das Eintauchen der Nanostrukturoberfläche 18 des Masterstempels 17 in das flüssige PDMS 12 wird die Nanostruktur ohne Blasenbildung in das flüssige PDMS 12 auf der Oberseite 14 des Trägers 7 übertragen. Gleichzeitig wird überschüssiges PDMS 37 in den porösen Träger 7 eingesaugt. Nach dem Einsaugen der gewünschten Menge an PDMS 37 in den starren Träger 7 und/oder nach Erreichen einer vorgegebenen Position des Masterstempels 17 beginnt der Aushärteprozess mittels der Heizwendel 25, 35. Hierdurch härtet die Nanostempelstruktur 3 aus PDMS sowie die Justierungsmarken 39 auf der der Nanostempelstruktur 3 gegenüberliegenden Seite des Trägers 7 aus. Durch die gleichzeitige Aushärtung wird eine definierte Zuordnung der Jusciemngsmarken 39 zu der Nanostempelstruktur 3 erreicht.

Nach dem Aushärteprozess wird der erste Kammerabschnitt 4 um das Gelenk 6 in Öffnungsstellung verschwenkt, woraufhin der fertige Stempel, bestehend aus Träger 7, Nanostempelstruktur 3 sowie Justierungsmarken 39 entnommen werden kann.

Die Vorrichtung ist nun bereit zur Herstellung eines weiteren, großflächigen Nanostrukturstempels.

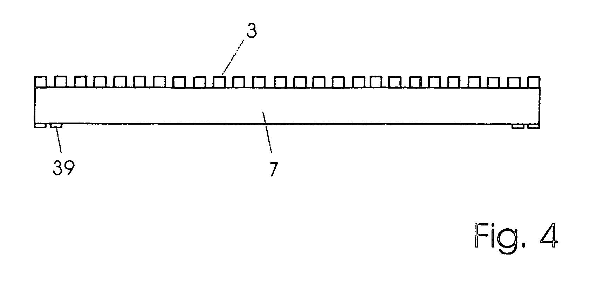

In Fig. 4 ist ein erfindungsgemäßer, großflächiger Stempel 2 mit einer Nanostempelstruktur 3, einem porösen Träger 7 sowie mit Justierungsmarken 39 gezeigt. Die Oberseite und die Unterseite des Stempels 2 sind eben parallel ausgebildet.

### Bezugszeichenliste

- 1: Vorrichtung
- 2: Stempel
- 3: Nanostempelstruktur
- 4: erster Kammerabschnitt
- 5: zweiter Kammerabschnitt
- 6: Schwenkgelenk
- 7: Träger
- 8: Randbereich
- 9: Justierungsmarkenstempel
- 10: Justierungsmarkenstruktur
- 11: erste Düse (erstes Aufbringmittel)
- 12: PDMS
- 13: Zuleitung
- 14: Oberseite des Trägers
- 15: zweite Düse (zweites Aufbringmittel)
- 16: Zuleitung
- 17: Masterstempel
- 18: Nanostrukturoberfläche
- 19: Umfangswand
- 20: O-Ringe
- 21: Oberseite
- 22: Umfangswand
- 23: Ringdichtung
- 24: Hohlraum
- 25: Heizwendel
- 26: erste Vakuumleitung
- 27: PDMS
- 28: Ringnut
- 29: zweite Vakuum-/Druckleitung
- 30: Seite
- 31: Messeinrichtung
- 32: Messeinrichtung
- 33: dritte Vakuum-/Druckleitung
- 34: zweiter Hohlraum
- 35: Heizwendel
- 36: Kammer
- 37: Teilmenge
- 38: Teilmenge
- 39: Justierungsmarken

## Patentansprüche

1. Stempel (2) mit einer Nanostempelstruktur (3) zur Aufbringung von Nanostrukturen auf Bauteile, wobei
der Stempel (2) einen starren Träger (7) für die Nanostempelstruktur (3) aufweist, die Nanostempelstruktur (3) mit dem Träger (7) verbunden ist und die Nanostempelstruktur (3) aus einem ausgehärteten Polymer besteht,
**dadurch gekennzeichnet, dass**
der Träger (7), zumindest in einem Teilbereich, aus porösem und/oder mit Kanälen durchzogenem Material besteht, und die erhabenen Strukturen der Nanostempelstruktur (3) unmittelbar an den starren Träger (7) anschließen.

2. Stempel nach Anspruch 1,
**dadurch gekennzeichnet, dass**
die Nanostempelstruktur (3) aus einem Elastomer, vorzugsweise einem Siloxan, bevorzugt aus Poly-Dimethyl-Siloxan (PDMS) (12), besteht.

3. Stempel nach Anspruch 2,
**dadurch gekennzeichnet, dass**
der Träger (7) zumindest in Teilbereichen aus Keramik, vorzugsweise gesinterter Keramik, besteht.

4. Stempel nach einem der Ansprüche 2 oder 3,
**dadurch gekennzeichnet, dass**
eine Teilmenge (37) des ausgehärteten Polymers in die Poren oder die Kanäle des starren Trägers (7) eingedrungen ist

5. Stempel nach einem der vorhergehenden Ansprüche,
**dadurch gekennzeichnet, dass**
der Stempel (2) Justierungsmittel (39) aufweist.

6. Stempel nach Anspruch 5,
**dadurch gekennzeichnet, dass**
die Justierungsmittel (39) auf einer der Nanostempelstruktur (3) gegenüberliegenden Seite des Trägers (7) angeordnet sind.

7. Stempel nach einem der Ansprüche 5 oder 6,
**dadurch gekennzeichnet, dass**
die Justierungsmittel (39) als dreidimensionale Justierungsmarken (39) ausgebildet sind.

8. Stempel nach Anspruch 7
**dadurch gekennzeichnet, dass**
die Justierungsmarken (39) aus einem ausgehärteten Polymer, insbesondere einem Elastomer, vorzugsweise einem Siloxan, bevorzugt aus Poly-Dimethyl-Siloxan (PDMS) (27) bestehen.

9. Stempel nach einem der Ansprüche 7 oder 8,
**dadurch gekennzeichnet, dass**
die Justierungsmarken (39) aus einem anderem Material bestehen als die Nanostempelstruktur (3) .

10. Vorrichtung zur Herstellung eines Stempels (2) mit einer
Nanostempelstruktur (3), insbesondere nach einem der vorhergehenden Ansprüche, wobei
die Vorrichtung (1) folgende Bauteile umfasst:
o ein Aufnahmemittel (5) zur Aufnahme eines starren Träger (7);
o mindestens einen relativ zu dem starren Träger (7) bewegbaren Masterstempel (17) mit einer Nanostrukturoberfläche (18);
o mindestens ein Aufbringmittel (11) zum Aufbringen eines fließfähigen, aushärtbaren Polymers, insbesondere eines Elastomers, vorzugsweise eines Siloxans, bevorzugt von Poly-Dimethyl-Siloxans (PDMS) (12) auf den zumindest in einem Teilbereich aus porösem und/oder mit Kanälen durchzogenen Material bestehenden Träger (7) und/oder den Masterstempel (17)
**dadurch gekennzeichnet, dass**
mindestens eine erste Vakuumleitung (26) zum Anlegen eines Vakuums an den Träger (7), und Einsaugen des fließenden Polymers in die Poren und/oder Kanäle des Trägers (7), vorgesehen ist.

11. Vorrichtung nach Anspruch 10,
**dadurch gekennzeichnet, dass**
die Seite (14) des Trägers (7), auf die die Nanostempelstruktur (3) aufgebracht wird, parallel zu der Nanostrukturoberfläche (18) des Masterstempel (17) anordnenbar ist, vorzugsweise derart, dass der Masterstempel (17) über dem starren Träger (7) angeordnet ist und die Nanostrukturoberfläche (18) des Masterstempels (17) nach unten in Richtung des starren Trägers (7) gerichtet ist.

12. Vorrichtung nach einem der Ansprüche 10 bis 11,
**dadurch gekennzeichnet, dass**
eine abdichtbare Kammer (36) für den Masterstempel (17) und den starren Träger (7) mit einer Umfangswand (19, 22) vorgesehehn ist.

13. Vorrichtung nach einem der Ansprüche 10 bis 12,
**dadurch gekennzeichnet, dass**
eine oder mehrere Messeinrichtung(en) (31, 32) zur Messung der Position des Masterstempels (17) und/oder des Trägers (7) vorgesehen ist.

14. Vorrichtung nach einem der Ansprüche 10 bis 13,
**dadurch gekennzeichnet, dass**
der Masterstempel (17) innerhalb der Kammer (36) translatorisch auf den Träger (7) zu, vorzugsweise bis zum Träger (7), bewegbar ist.

15. Vorrichtung nach einem der Ansprüche 10 bis 14,
**dadurch gekennzeichnet, dass**
der Masterstempel (17) gegenüber der Umfangswand (19, 22) der Kammer (36) abgedichtet ist und dass mindestens eine zweite Vakuum- und/oder Druckleitung (29) zum Anlegen eines Vakuums oder eines Überdrucks auf der der Nanostrukturoberfläche (18) gegenüberliegenden Seite des Masterstempels (17) vorgesehen ist.

16. Vorrichtung nach Anspruch 15,
**dadurch gekennzeichnet, dass**
mindestens eine dritte Vakuum- und/oder Druckleitung (33) zum Anlegen eines Vakuums oder eines Überdrucks in einem Bereich zwischen dem Masterstempel (17) und dem Träger (7) vorgesehen ist.

17. Vorrichtung nach einem der Ansprüche 10 bis 16,
**dadurch gekennzeichnet, dass**
mindestens ein Justierungsmarkenstempel (9) zum Einbringen einer dreidimensionalen Justierungsmarke (39) in die von dem Masterstempel (17) abgewandte Seite des Trägers (7) vorgesehen ist.

18. Vorrichtung nach Anspruch 17,
**dadurch gekennzeichnet, dass**
der Justierungsmarkenstempel (9) als Ring ausgebildet ist.

19. Vorrichtung nach einem der Ansprüche 17 oder 18,
**dadurch gekennzeichnet, dass**
mindestens ein zweites Aufbringmittel (15) zum Aufbringen eines fließfähigen, aushärtbaren Polymers, insbesondere einem Elastomers, vorzugsweise eines Siloxans, bevorzugt von Poly-Dimethyl-Siloxan (PDMS) (27) auf den Justierungsmarkenstempel (9) und/oder die von dem Masterstempel (17) abgewandte Seite des Trägers (7) vorgesehen ist.

20. Vorrichtung nach einem der Ansprüche 1 bis 19,
**dadurch gekennzeichnet, dass**
mindestens eine Aushärteinrichtung (25, 35), vorzugsweise eine Heizung (25, 35), zur Aushärtung der Nanostempelstruktur (3) und/oder der dreidimensionalen Justierungsmarken (39) vorgesehen ist.

21. Vorrichtung nach Anspruch 20,
**dadurch gekennzeichnet, dass**
mindestens eine Heizung (25, 35) auf der der Nanostrukturoberfläche (18) gegenüberliegenden Seite des Masterstempels (17) vorgesehen ist und/oder dass mindestens eine Heizung (25, 35) auf der von dem Masterstempel (17) abgewandten Seite des Trägers (7) vorgesehen ist.

22. Vorrichtung nach einem der Ansprüche 10 bis 21,
**dadurch gekennzeichnet, dass**
die Kammer (36) einen ersten Kammerabschnitt (4) für den Masterstempel (17) und einen gegenüber dem ersten Kammerabschnitt (4) abdichtbaren zweiten Kammerabschnitt (5) für den Träger (7) aufweist und dass Mittel (6) zum Öffnen und Schließen der Kammer (36) durch Bewegung mindestens eines Kammerabschnitts (4, 5) vorgesehen sind.

23. Vorrichtung nach Anspruch 22,
**dadurch gekennzeichnet, dass**
beide Kammerabschnitte (4, 5) über mindestens ein Schwenkgelenk (6) gelenkig miteinander verbunden sind.

24. Vorrichtung nach einem der Ansprüche 22 oder 23,
**dadurch gekennzeichnet, dass**
mindestens ein Kammerabschnitt (24, 25) translatorisch auf den jeweils anderen Kammerabschnitt (25, 24) zu bewegbar ist.

25. Verfahren zur Herstellung eines Stempels (2) nach einem der
Ansprüche 1 bis 9, insbesondere mit einer Vorrichtung (1) gemäß der Ansprüche 10 bis 24, wobei
das Verfahren folgende Verfahrensschritte umfasst:
o Aufbringen eines fließfähigen, aushärtbaren Polymers, insbesondere eines Elastomers, vorzugsweise eines Siloxans, bevorzugt von Poly-Dimethyl-Siloxans (PDMS) (12) auf einen starren Träger (7) und/oder einen Masterstempel (17) mit einer Nanostrukturoberfläche (18);
○ Verringerung des Abstandes zwischen dem Masterstempel (17) und dem starren Träger (7) und **dadurch** Einbringen der Nanostruktur des Masterstempels (17) in das fließfähige Polymer (12)
○ Aushärten des Polymers (12),
**dadurch gekennzeichnet, dass**
ein Vakuum an den zumindest in einem Teilbereich aus porösem Material bestehenden und/oder mit Kanälen durchzogenen Träger (7) angelegt wird und **dadurch** eine Teilmenge (37) des Polymers (12) in den Träger (7) eingesaugt wird.

26. Verfahren nach einemd er Ansprüche 24 oder 25,
**dadurch gekennzeichnet, dass**
eine dreidimensionale Justierungsmarke (39) in den Träger (7), vorzugsweise in die dem Masterstempel (17) abgewandte Seite des Trägers (7), eingebracht wird.

27. Verfahren nach Anspruch 26,
**dadurch gekennzeichnet, dass**
die dreidimensionalen Justierungsmarken (39) und die Nanostempelstruktur (3) gleichzeitig ausgehärtet werden.

## Claims

1. Stamp (2) with a nanostamping structure (3) for the application of nanostructures on components, wherein the stamp (2) comprises a rigid support (7) for the nanostamping structure (3), the nanostamping structure (3) is joined to the support (7) and the nanostamping structure (3) consists of a hardened polymer, **characterised in that** the support (7) consists, at least in a partial region, of porous material and/or material penetrated by channels and wherein raised structures (3e) of the nanostamping structure (3) follow directly on the rigid support (7).

2. Stamp according to claim 1, **characterised in that** the nanostamping structure (3) consists of an elastomer, preferably a siloxane, specifically poly(dimethylsiloxane) (PDMS) (12).

3. Stamp according to claim 2, **characterised in that** the support (7) consists, at least in partial regions, of ceramic material, preferably sintered ceramic material.

4. Stamp according to one of claims 2 or 3, **characterised in that** a partial amount (37) of the hardened polymer is forced into the pores and/or the channels of the rigid support (7).

5. Stamp according to one of the preceding claims, **characterised in that** the stamp (2) comprises adjustment means (39).

6. Stamp according to claim 5, **characterised in that** the adjustment means (39) are arranged on a side of the support (7) lying opposite the nanostamping structure (3).

7. Stamp according to one of claims 5 or 6, **characterised in that** the adjustment means (39) are formed as three-dimensional adjustment markers (39).

8. Stamp according to claim 7, **characterised in that** the adjustment markers (39) consist of a hardened polymer, in particular an elastomer, preferably a siloxane, and specifically poly(dimethylsiloxane) (PDMS) (27).

9. Stamp according to one of claims 7 and 8, **characterised in that** the adjustment markers (39) consist of a different material to the nanostamping structure (3).

10. Device for the production of a stamp (2) with a nanostamping structure (3), in particular according to one of the preceding claims, wherein the device (1) includes the following structural parts:
• a receiving means (5) for receiving a rigid support (7) ;
• at least one master stamp (17) with a nanostructure surface (18), movable relative to the rigid support (7);
• at least one application means (11) for applying a flowable, hardenable polymer, in particular an elastomer, preferably a siloxane and specifically polymer(dimethylsiloxane) (PDMS) (12) to the support (7) consisting at least in a partial region of porous material and/or material penetrated by channels and/or to the master stamp (17), **characterized in that**
• at least a first vacuum line (26) for applying a vacuum to the support (7) and for suction of the flowing polymer into the pores and/or channels of the support (7).

11. Device according to claim 10, **characterised in that** the side (14) of the support (7) on which the nanostamping structure (3) is applied can be arranged parallel to the nanostructure surface (18) of the master stamp (17), preferably in such a way that the master stamp (17) is arranged above the rigid support (7) and the nanostructure surface (18) of the master stamp (17) is aligned downwardly in the direction of the rigid support (7).

12. Device according to one of claims 10 or 11, **characterised in that** the master stamp (17) can be moved within the chamber (36) in a translational manner to the support (7), preferably up to the support (7).

13. Device according to one of claims 10 to 12, **characterised in that** one or more measuring devices (31, 32) is/are provided for measuring the position of the master stamp (17) and/or of the support (7).

14. Device according to one of claims 10 to 13, **characterised in that** the masterstamp (17) is movable within the chamber (36) to the carrier (7) in a translational manner, preferably until the carrier (7).

15. Device according to one of claims 10 to 14, **characterised in that** the master stamp (17) is sealed against the circumferential wall (19, 22) of the chamber (36) and that at least a second vacuum and/or pressure line (29) is provided for applying a vacuum or an excess pressure to the side of the master stamp (17) lying opposite the nanostructure surface (18).

16. Device according to claim 15, **characterised in that** at least a third vacuum and/or pressure line (33) is provided for applying a vacuum or an excess pressure in a region between the master stamp (17) and the support (7).

17. Device according to one of claims 10 to 16, **characterised in that** at least one adjustment marker stamp (9) is provided for introducing a three-dimensional adjustment marker (39) into the side of the support (7) facing away from the master stamp (17).

18. Device according to claim 17, **characterised in that** the adjustment marker stamp (9) is designed as a ring.

19. Device according to one of claims 17 or 18, **characterised in that** at least a second application hardenable polymer, in particular an elastomer, preferably a siloxane, specifically poly(dimethylsiloxane) (PDMS) (27) to the adjustment master stamp (9) and/or to the side of the support (7) facing away from the master stamp (17).

20. Device according to one of claims 10 to 19, **characterised in that** at least one hardening device (25, 35), preferably a heating means (25, 35), is provided for hardening the nanostamping structure (3) and/or the three-dimensional adjustment markers (39).

21. Device according to claim 20, **characterised in that** at least one heating means (25, 35) is provided on the side of the master stamp (17) lying opposite the nanostructure surface (18) and/or that at least one heating means (25, 35) is provided on the side of the support (7) facing away from the master stamp (17).

22. Device according to one of claims 10 to 21, **characterised in that** the chamber (36) comprises a first chamber section (4) for the master stamp (17) and a second chamber section (5), which can be sealed with respect to the first chamber section (4), for the support (7), and that means are provided for opening and closing the chamber (36) by moving at least one chamber section (4, 5).

23. Device according to claim 22, **characterised in that** both chamber sections (4, 5) are articulatedly connected to one another via a swivel linkage (6).

24. Device according to one of claims 22 or 23, **characterised in that** at least one chamber section (24, 25) can be moved in a translational manner to the respective other chamber section (25, 24).

25. Method for producing a stamp (2) according to one of claims 1 to 9, in particular with a device (1) according to claims 10 to 24, wherein the method comprises the following process steps:
• application of a flowable, hardenable polymer, in particular an elastomer, preferably a siloxane, specifically poly(dimethylsiloxane) (PDMS) (12) to a rigid support (7) and/or to a master stamp (17) with a nanostructure surface (18);
• reducing the distance between the master stamp (17) and the rigid support (7) and thereby introducing the nanostructure of the master stamp (17) into the flowable polymer (12) to produce a nanostamping structure (3) with raised structures (3e) and depressions (3v) adjacent to the raised structures (3e), until there is an at least partial contacting of the master stamp (17) with the rigid support (7);
• hardening the polymer (12) **characterised in that** a vacuum is applied to the support (7) consisting at least in a partial region of porous material and/or that is penetrated by channels, a partial amount (37) of the polymer (12) thereby being aspirated into the support (7).

26. Method according to one of claims 24 and 25, **characterised in that** a three-dimensional adjustment marker (39) is introduced into the support (7), preferably into the side of the support (7) facing away from the master stamp (17).

27. Method according to claim 26, **characterised in that** the three-dimensional adjustment markers (39) and the nanostamping structure (3) are simultaneously hardened.

## Revendications

1. Poinçon (2) comprenant une nanostructure de poinçon (3) pour appliquer des nanostructures sur des pièces, dans lequel
le poinçon (2) présente un support (7) rigide pour la nanostructure de poinçon (3), la nanostructure de poinçon (3) est reliée au support (7) et la nanostructure de poinçon (3) est composée d'un polymère durci,
**caractérisé en ce que**
le support (7), au moins dans une zone partielle, est composé d'un matériau poreux et/ou traversé de canaux, et que des structures en relief de la nanostructure de poinçon (3) sont rattachées directement sur le support (7) rigide.

2. Poinçon selon la revendication 1,
**caractérisé en ce que**
la nanostructure de poinçon (3) est composée d'un élastomère, de préférence d'un siloxane, de préférence en polydiméthylsiloxane (PDMS) (12).

3. Poinçon selon la revendication 2,
**caractérisé en ce que**
le support (7), au moins dans des zones partielles, est composé de céramique, de préférence de céramique frittée.

4. Poinçon selon l'une des revendications 2 ou 3,
**caractérisé en ce qu'**
une quantité partielle (37) du polymère durci est infiltrée dans les pores ou les canaux du support (7) rigide.

5. Poinçon selon l'une des revendications précédentes,
**caractérisé en ce que**
le poinçon (2) présente des moyens d'ajustage (39).

6. Poinçon selon la revendication 5,
**caractérisé en ce que**
les moyens d'ajustage (39) sont disposés sur un côté du support (7) faisant face à la nanostructure de poinçon (3).

7. Poinçon selon l'une des revendications 5 ou 6,
**caractérisé en ce que**
les moyens d'ajustage (39) sont formés en tant que repères d'ajustage tridimensionnels (39).

8. Poinçon selon la revendication 7,
**caractérisé en ce que**
les moyens d'ajustage (39) sont composés d'un polymère durci, en particulier d'un élastomère, de préférence d'un siloxane, de préférence en polydiméthylsiloxane (PDMS) (27).

9. Poinçon selon l'une des revendications 7 ou 8,
**caractérisé en ce que**
les moyens d'ajustage (39) sont composés d'un autre matériau que la nanostructure de poinçon (3).

10. Dispositif pour fabriquer un poinçon (2) comprenant une nanostructure de poinçon (3), en particulier selon l'une des revendications précédentes, dans lequel
le dispositif (1) présente les pièces suivantes :
- un moyen de réception (5) pour recevoir un support (7) rigide ;
- au moins un poinçon maître (17) comprenant une surface de nanostructure (18) mobile par rapport au support (7) rigide ;
- au moins un moyen d'application (11) pour appliquer un polymère fluide et durcissable, en particulier un élastomère, de préférence un siloxane, de préférence du polydiméthylsiloxane (PDMS) (12) sur le support (7) composé, au moins dans une zone partielle, d'un matériau poreux et/ou traversé de canaux, et/ou sur le poinçon maître (17),
**caractérisé en ce qu'**au moins
un premier conduit de vide (26) est prévu pour appliquer un vide sur le support (7) et aspirer le polymère fluide dans les pores et/ou les canaux du support (7).

11. Dispositif selon la revendication 10,
**caractérisé en ce que**
le côté (14) du support (7), sur lequel la nanostructure de poinçon (3) est appliquée, peut être disposé parallèlement à la surface de nanostructure (18) du poinçon maître (17), de préférence de telle sorte que le poinçon maître (17) soit disposé sur le support (7) rigide et que la surface de nanostructure (18) du poinçon maître (17) soit dirigée vers le bas en direction du support (7) rigide.

12. Dispositif selon l'une des revendications 10 à 11,
**caractérisé en ce qu'**
une chambre (36) pouvant être étanchéifiée pour le poinçon maître (17) et le support (7) rigide est dotée d'une paroi périphérique (19, 22).

13. Dispositif selon l'une des revendications 10 à 12,
**caractérisé en ce qu'**
un ou plusieurs dispositif(s) de mesure (31, 32) est/sont prévu(s) pour mesurer la position du poinçon maître (17) et/ou le support (7).

14. Dispositif selon l'une des revendications 10 à 13,
**caractérisé en ce que**
le poinçon maître (17) est mobile de manière translationnelle en direction du support (7), de préférence jusqu'au support (7), à l'intérieur de la chambre (36).

15. Dispositif selon l'une des revendications 10 à 14,
**caractérisé en ce que**
le poinçon maître (17) est étanchéifié par rapport à la paroi périphérique (19, 22) de la chambre (36) et qu'au moins un deuxième conduit de vide et/ou de pression (29) est prévu pour appliquer un vide ou une surpression sur le côté du poinçon maître (17) faisant face à la surface de nanostructure (18).

16. Dispositif selon la revendication 15,
**caractérisé en ce qu'**
au moins un troisième conduit de vide et/ou de pression (33) est prévu pour appliquer un vide ou une surpression dans une zone entre le poinçon maître (17) et le support (7).

17. Dispositif selon l'une des revendications 10 à 16,
**caractérisé en ce qu'**
au moins un poinçon de repère d'ajustage (9) est prévu pour intégrer un repère d'ajustage (39) tridimensionnel dans le côté du support (7) détourné du poinçon maître (17).

18. Dispositif selon la revendication 17,
**caractérisé en ce que**
le poinçon de repère d'ajustage (9) est formé comme une bague.

19. Dispositif selon l'une des revendications 17 ou 18,
**caractérisé en ce qu'**
au moins un second moyen d'application (15) est prévu pour appliquer un polymère fluide et durcissable, en particulier un élastomère, de préférence un siloxane, de préférence du polydiméthylsiloxane (PDMS) (27) sur le poinçon de repère d'ajustage (9) et/ou le côté du support (7) détourné du poinçon maître (17).

20. Dispositif selon l'une des revendications 1 à 19,
**caractérisé en ce qu'**
au moins un dispositif de durcissement (25, 35), de préférence un chauffage (25, 35), est prévu pour durcir la nanostructure de poinçon (3) et/ou les repères d'ajustage tridimensionnels (39).

21. Dispositif selon la revendication 20,
**caractérisé en ce qu'**
au moins un chauffage (25, 35) est prévu sur le côté du poinçon maître (17) faisant face à la surface de nanostructure (18) et/au qu'au moins un chauffage (25, 35) est prévu sur le côté du support (7) détourné du poinçon maître (17).

22. Dispositif selon l'une des revendications 10 à 21,
**caractérisé en ce que**
la chambre (36) présente une première section de chambre (4) pour le poinçon maître (17) et une seconde section de chambre (5) pour le support (7), pouvant être étanchéifiée vis-à-vis de la première section de chambre (4), et **en ce que** des moyens (6) sont prévus pour ouvrir et fermer la chambre (36) par le mouvement d'au moins une des sections de chambre (4, 5).

23. Dispositif selon la revendication 22,
**caractérisé en ce que**
les deux sections de chambre (4, 5) sont reliées entre elles de manière articulée par au moins une articulation pivotante (6).

24. Dispositif selon l'une des revendications 22 ou 23,
**caractérisé en ce qu'**
au moins une section de chambre (24, 25) est mobile de manière translationnelle en direction de l'autre section de chambre (25, 24) respective.

25. Procédé pour fabriquer un poinçon (2) selon l'une des revendications 1 à 9, comprenant en particulier un dispositif (1) selon l'une des revendications 10 à 24, dans lequel
le procédé comprend les étapes de procédé suivantes :
- l'application d'un polymère fluide et durcissable, en particulier d'un élastomère, de préférence de siloxane, de préférence du polydiméthylsiloxane (PDMS) (12) sur un support rigide (7) et/ou un poinçon maître (17) comprenant une surface de nanostructure (18) ;
- réduction de l'écart entre le poinçon maître (17) et le support (7) rigide et par cela pénétration de la nanostructure du poinçon maître (17) dans le polymère fluide (12) ;
- durcissement du polymère (12),
**caractérisé en ce qu'**
un vide est appliqué sur le support (7) se composant au moins d'un matériau poreux dans une zone partielle et/ou traversé par des canaux, et qu'une quantité partielle (37) du polymère (12) est aspirée dans le support (7).

26. Procédé selon l'une des revendications 24 ou 25,
**caractérisé en ce qu'**
un repère d'ajustage tridimensionnel (39) est introduit dans le support (7), de préférence dans le côté du support (7) détourné du poinçon maître (17).

27. Procédé selon la revendications 26,
**caractérisé en ce que**
les repères d'ajustage tridimensionnels (39) et la nanostructure de poinçon (3) sont durcis en même temps.
